(19) Europäisches Patentamt
European Patent Office
Office européen des brevets

(11) **EP 4 624 439 A1**

(12) **EUROPEAN PATENT APPLICATION**
published in accordance with Art. 153(4) EPC

(43) Date of publication:
**01.10.2025  Bulletin 2025/40**

(21) Application number: **23894413.6**

(22) Date of filing: **07.11.2023**

(51) International Patent Classification (IPC):
***C04B 35/587*** (2006.01)   ***H01L 23/15*** (2006.01)

(52) Cooperative Patent Classification (CPC):
**C04B 35/587; H01L 23/15**

(86) International application number:
**PCT/JP2023/040093**

(87) International publication number:
**WO 2024/111402 (30.05.2024 Gazette 2024/22)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **21.11.2022  JP 2022185363**

(71) Applicants:
• **Kabushiki Kaisha Toshiba
  Tokyo 105-0023 (JP)**
• **Toshiba Materials Co., Ltd.
  Isogo-Ku
  Yokohama-Shi
  Kanagawa 235-0032 (JP)**

(72) Inventors:
• **AOKI, Katsuyuki
  Yokohama-shi
  Kanagawa 235-0032 (JP)**
• **YAMAGATA, Yoshihito
  Yokohama-shi
  Kanagawa 235-0032 (JP)**
• **IWAI, Kentaro
  Yokohama-shi
  Kanagawa 235-0032 (JP)**
• **FUKASAWA, Takayuki
  Yokohama-shi
  Kanagawa 235-0032 (JP)**
• **HOUTSUKI, Naoto
  Yokohama-shi
  Kanagawa 235-0032 (JP)**

(74) Representative: **Hoffmann Eitle
Patent- und Rechtsanwälte PartmbB
Arabellastraße 30
81925 München (DE)**

(54) **SILICON NITRIDE SINTERED COMPACT, SILICON NITRIDE SUBSTRATE, SILICON NITRIDE CIRCUIT BOARD, AND SEMICONDUCTOR DEVICE**

(57)    Provided is a highly heat-conductive silicon nitride sintered compact capable of achieving the improvement in both of a heat conductivity and a relative permittivity. The highly thermally-conductive silicon nitride sintered compact according to an embodiment includes silicon nitride crystal grains and a grain boundary phase. The thermal conductivity of the silicon nitride sintered compact is not less than 100 W/m·K. A grain boundary phase present in a 5 μm×5 μm measurement area in any cross section includes Mg and a rare-earth element (RE). The atom ratio of Mg to rare-earth element is within the range of not less than 0.01 and not more than 1.5. A relative dielectric constant $\varepsilon 10M\text{-}25$ at 10 MHz and room temperature is not more than 9.0.

FIG. 1

**Description**

[Technical Field]

Embodiments below relate generally to a silicon nitride sintered compact, a silicon nitride substrate, a silicon nitride circuit board, and a semiconductor device.

[Background Art]

A highly thermally-conductive silicon nitride sintered compact that has a thermal conductivity of not less than 80 W/m·K and a three-point bending strength of not less than 600 MPa is being developed. The highly thermally-conductive silicon nitride sintered compact is used in silicon nitride substrates and silicon nitride circuit boards.

On the other hand, in recent years, the performance of semiconductor elements is being increased. Operating frequencies are increasing with the higher performance of semiconductor elements. The operating frequencies of power ICs, IGBTs, MOSFETs, and the like are about 100 Hz to 1 MHz. Also, the operating frequencies of GaN devices may be greater than 1 MHz. Due to the higher operating frequencies, it is predicted that the heat generation amounts also will increase.

For example, the distribution of a grain boundary phase in a thickness direction of a silicon nitride substrate is controlled in Japanese Patent No. 6293772 (Patent Literature 1). As a result, $(\varepsilon_{r50} - \varepsilon_{r1000})/\varepsilon_{r50} \leq 0.1$ is satisfied, wherein $\varepsilon_{r50}$ is the relative dielectric constant at 50 Hz, and $\varepsilon_{r1000}$ is the relative dielectric constant at 1 kHz. Improving the frequency dependence of the relative dielectric constant makes it difficult for polarization of the silicon nitride substrate to occur.

International Publication No. 2018/194052 (Patent Literature 2) discusses the measurement of dielectric loss by continuously changing the frequency of an AC voltage from 50 Hz to 1 MHz while applying the AC voltage to a silicon nitride substrate. Improving the frequency dependence of the dielectric loss makes it difficult for polarization of the silicon nitride substrate to occur.

[Prior Art Documents]

[Patent Literature]

Patent Literature 1: Japanese Patent No. 6293772
Patent Literature 2: International Publication No. 2018/194052
Patent Literature 3: JP-A 2022-153934 (Kokai)
Patent Literature 4: JP-A 2022-71426 (Kokai)

[Summary of Invention]

[Problem to be Solved by the Invention]

The frequency dependence is improved for the relative dielectric constant or dielectric loss in Patent Literature 1 or Patent Literature 2. In both cases, silicon nitride substrate polarization is suppressed within a frequency range of 50 Hz to 1 MHz. On the other hand, there were substrates for which the insulative properties could not be maintained when the frequency was greater than 1 MHz. Also, the thermal conductivity was about 95 W/m·K for the silicon nitride sintered compacts described in Patent Literature 1 and Patent Literature 2. There is a need to further improve the heat dissipation in preparation for the increased heat generation amount of semiconductor elements.

JP-A 2022-153934 (Kokai) (Patent Literature 3) describes a silicon nitride sintered compact in which a mass ratio of Mg to rare-earth element in a grain boundary phase of silicon nitride crystal grains is controlled to be not more than 1, and the thermal conductivity is not less than 130 W/m·K. According to Patent Literature 3, a silicon nitride sintered compact that has a high thermal conductivity is obtained. On the other hand, there are cases where locations at which the Mg/rare-earth element mass ratio is small are formed partially in the grain boundary phase. Therefore, the insulative properties of the silicon nitride sintered compact described in Patent Literature 3 are equivalent to the insulative properties of the silicon nitride sintered compacts described in Patent Literature 1 and Patent Literature 2.

Conventionally, it has not been possible to realize both an improvement of the frequency dependence of the insulative properties and an improvement of the thermal conductivity. Embodiments of the invention are directed to address such problems. Embodiments are directed to provide a highly thermally-conductive silicon nitride sintered compact in which the high thermal conductivity is improved and the frequency dependence of the insulative properties is improved.

[Means for Solving the Problem]

A highly thermally-conductive silicon nitride sintered compact according to an embodiment includes silicon nitride crystal grains and a grain boundary phase. The thermal conductivity of the silicon nitride sintered compact is not less than 100 W/m·K. The grain boundary phase present in a 5 μm×5 μm measurement area in any cross section includes Mg and a rare-earth element (RE). The atom ratio of Mg to rare-earth element is within the range of not less than 0.01 and not more than 1.5. A relative dielectric constant $\varepsilon_{10M\text{-}25}$ at 10 MHz and room temperature is not more than 9.0.

[Brief Description of Drawings]

[FIG. 1]

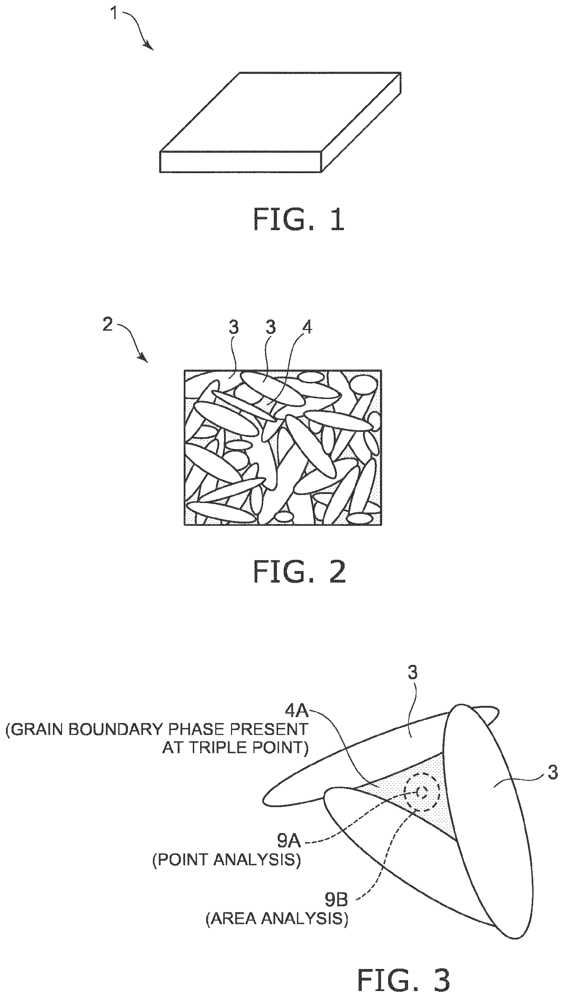

FIG. 1 is a drawing showing an example of a silicon nitride substrate (a silicon nitride sintered compact) according to an embodiment.
[FIG. 2]
FIG. 2 is a drawing showing an example of a cross-sectional composition of the silicon nitride sintered compact according to the embodiment.
[FIG. 3]
FIG. 3 is a drawing showing an example of a triple point.
[FIG. 4]

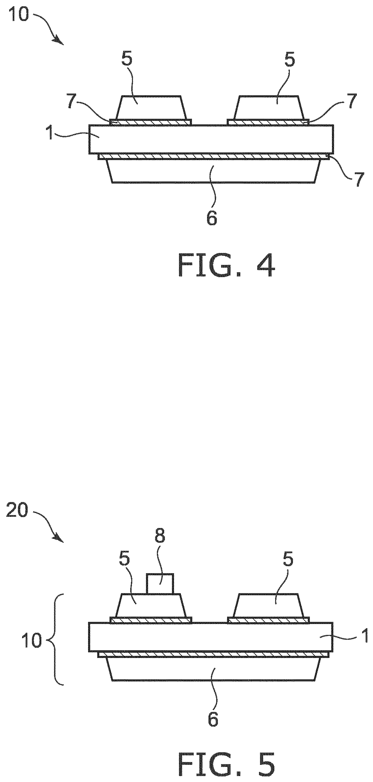

FIG. 4 is a drawing showing an example of a silicon nitride circuit board according to an embodiment.
[FIG. 5]
FIG. 5 is a drawing showing an example of a semiconductor device according to an embodiment.

[Description of Embodiments]

A highly thermally-conductive silicon nitride sintered compact according to an embodiment includes silicon nitride crystal grains and a grain boundary phase. The thermal conductivity of the silicon nitride sintered compact is not less than 100 W/m·K. A grain boundary phase present in a 5 μm×5 μm measurement area in any cross section includes Mg and a rare-earth element (RE). The atom ratio of Mg to rare-earth element is within the range of not less than 0.01 and not more than 1.5. A relative dielectric constant $\varepsilon_{10M\text{-}25}$ at 10 MHz and room temperature is not more than 9.0. It is noted that rare-earth elements also are referred to as RE.
FIG. 1 shows an example of a silicon nitride substrate according to an embodiment. FIG. 2 is a schematic view showing an example of a cross section of the silicon nitride substrate. In FIGS. 1 and 2, reference numeral 1 is the silicon nitride substrate, reference numeral 2 is the cross section, reference numeral 3 is a silicon nitride crystal grain, and reference numeral 4 is a grain boundary phase. FIG. 1 illustrates a silicon nitride substrate including a silicon nitride sintered compact that is highly thermally-conductive. The shape of the silicon nitride substrate 1 is not limited to a flat plate, and may be a circular shape (including an ellipse), an L-shape, an H-shape, an S-shape, etc. The silicon nitride substrate 1 may have a three-dimensional structure including steps and/or sidewalls. The silicon nitride substrate 1 may include conducting holes or screw holes (including a notched portion for screwing). As described below, the shape, structure, etc., of the silicon nitride substrate 1 are modifiable as appropriate as long as a circuit part can be located at the surface of the silicon nitride substrate 1 and as long as the silicon nitride substrate 1 can be used as a silicon nitride circuit board.
The thermal conductivity of the silicon nitride sintered compact according to the embodiment is not less than 100 W/m·K. Herein, a silicon nitride sintered compact that has a thermal conductivity of not less than 100 W/m·K is called a highly thermally-conductive silicon nitride sintered compact. The thermal conductivity is measured using the flash method.
The silicon nitride sintered compact according to the embodiment is characterized in that a grain boundary phase present in a 5 μm×5 μm measurement area in any cross section includes Mg and a rare-earth element; and the atom ratio of Mg to rare-earth element is within the range of not less than 0.01 and not more than 1.5. Herein, rare-earth elements also are called "RE".
As shown in FIG. 2, the cross section 2 of the silicon nitride substrate 1 includes the silicon nitride crystal grains 3 and the grain boundary phase 4. Pores, which are not illustrated, may be present in the cross section 2. The silicon nitride crystal grains 3 mainly have slender needle-like structures. The gaps between the silicon nitride crystal grains 3 are filled with the grain boundary phase 4.
The elements that are included in the grain boundary phase 4 include Mg and a rare-earth element (RE). Mg (magnesium) and the rare-earth element (RE) are based on components added as sintering aids. Mg and rare-earth elements are elements that improve the sinterability. By adding Mg and a rare-earth element, the grain growth of the silicon nitride crystal grains 3 can be controlled, and the distribution of the grain boundary phase 4 can be controlled. Examples of the rare-earth element include Y (yttrium) and lanthanoid elements. It is favorable for the lanthanoid element to be Er (erbium), Yb (ytterbium), Ce (cerium), Nd (neodymium), La (lanthanum), Lu (lutetium), etc. Also, it is favorable to add, as sintering aids, compounds such as oxides, nitrides, oxynitrides, and the like of Mg and rare-earth elements.

Also, the atom ratio of Mg to rare-earth element is within the range of not less than 0.01 and not more than 1.5 in the grain boundary phase 4 present in a 5 μm×5 μm measurement area in any cross section. Hereinafter, the atom ratio of Mg to rare-earth element also is called the atom ratio Mg/RE.

An area is selected as the "5 μm×5 μm measurement area" so that a grain boundary phase having an area ratio of not less than 10% is present within a 5 μm×5 μm area in any cross section. For example, an area is not employed as the "5 μm×5 μm measurement area" when large silicon nitride crystal grains 3 are present within the 5 μm×5 μm area, and the area ratio of the grain boundary phase within the area is less than 10% (including 0%).

The atom ratio Mg/RE being within the range of not less than 0.01 and not more than 1.5 in the grain boundary phase included in the 5 μm×5 μm measurement area indicates that both Mg and a rare-earth element are present in the grain boundary phase 4. It is important that both Mg and a rare-earth element are present in the grain boundary phase 4 in the micro region of the 5 μm×5 μm measurement area. The atom ratio Mg/RE being within the range of not less than 0.01 and not more than 1.5 can suppress polarization of the grain boundary phase 4. Also, it is favorable for the atom ratio Mg/RE to be within the range of not less than 0.01 and not more than 1.5, no matter which grain boundary phase included in any 5 μm×5 μm measurement area is measured.

Furthermore, the thermal conductivity of the silicon nitride substrate 1 is not less than 100 W/m·K. That is, for the silicon nitride substrate 1, polarization is suppressed while maintaining the high thermal conductivity. The size of the grain boundary phase, the presence of grain boundary phase components around pores, and the reduction of segregation regions are effective in controlling the polarization. To suppress polarization while maintaining the thermal conductivity at not less than 100 W/m·K, it is effective to reduce the segregation region. Polarization also occurs easily at the interface of different phases. Reducing the segregation region may reduce compositionally different phases, so that the polarization can be suppressed within a certain range.

The atom ratio Mg/RE being less than 0.01 or greater than 1.5 causes compositionally different phases; and polarization of the silicon nitride substrate 1 easily occurs. It is therefore favorable for the atom ratio Mg/RE to be within the range of not less than 0.01 and not more than 1.5, and more favorably within the range of not less than 0.1 and not more than 0.7. Also, it is favorable for the atom ratio Mg/RE to be within the range of not less than 0.01 and not more than 1.5 in any 5 μm×5 μm measurement area in any cross section.

Transmission Electron Microscopy. Energy (TEM)-Energy Dispersive X-ray Spectroscopy (EDS) is used to measure the Mg amount and the rare-earth element amount included in the grain boundary phase 4. The Mg amount and the rare-earth element amount are measured by performing point analysis or area analysis on the individual grain boundary phases 4 by using TEM-EDS. When multiple rare-earth elements are detected, the total of the multiple rare-earth elements is taken to be the rare-earth element amount. The Mg amount and the rare-earth element amount are respectively converted into amounts as simple metals. The atom ratio Mg/RE of Mg to rare-earth element is calculated by replacing the Mg amount and the rare-earth element amount respectively with the numbers of atoms. The Mg amount and the rare-earth element amount may be measured after performing qualitative analysis of the silicon nitride sintered compact beforehand to identify the constituent elements. In TEM-EDS, point analysis or area analysis is performed on the grain boundary phase 4 present at a triple point surrounded with the silicon nitride crystal grains present in the 5 μm×5 μm measurement area. The atom ratio Mg/RE is calculated for the individual grain boundary phases 4 present in the 5 μm×5 μm measurement area. The average value of the atom ratios Mg/RE is taken to be the overall atom ratio Mg/RE of the 5 μm×5 μm measurement area.

JEM-2100F made by JOEL or an equivalent apparatus is used for the TEM-EDS. The measurement conditions are set to an acceleration voltage of 200 kV, an irradiation current of 1 nA, and an elapsed time of 30 sec. The region to be measured is arbitrary as long as a grain boundary phase is present at a triple point, and point analysis and area analysis of the grain boundary phase can be performed. A triple point refers to a region surrounded with three or more silicon nitride crystal grains 3. FIG. 3 shows an example of a triple point. In FIG. 3, the reference numeral 3 is a silicon nitride crystal grain, and the reference numeral 4A is a grain boundary phase present at the triple point. The reference numeral 9A is a region measured by point analysis, and the reference numeral 9B is a region measured by area analysis. In FIG. 3, the region that is surrounded with three or more silicon nitride crystal grains 3 is taken to be the triple point. The triple point also is described in Patent Literature 3.

One of point analysis or area analysis is performed on the grain boundary phase 4A present at the triple point. Compared to area analysis, a narrower region 9A is measured by point analysis. Compared to point analysis, a wider region 9B is measured by area analysis. It is important not to include the silicon nitride crystal grains 3 in the measurement region when performing point analysis and area analysis. In other words, either point analysis or area analysis may be performed, as long as the silicon nitride crystal grains 3 are not included in the measurement region. Point analysis or area analysis is selected to match the size of the grain boundary phase 4. Also, only one point analysis or one area analysis is performed on one grain boundary phase 4A present at one triple point. For example, it is unnecessary to perform multiple point analyses for different positions in one grain boundary phase 4A.

The Mg amount and the rare-earth element amount may be measured by scanning electron microscopes (SEM)-EDS instead of TEM-EDS.

When the atom ratio Mg/RE is measured in 5 $\mu$m$\times$5 $\mu$m measurement areas that are adjacent to each other, it is favorable for the difference between the atom ratios Mg/RE to be not more than 0.8. The difference between the atom ratios Mg/RE of the 5 $\mu$m$\times$5 $\mu$m measurement areas that are adjacent to each other being not more than 0.8 indicates that partial fluctuation of the atom ratio is suppressed. Both high thermal conductivity improvement and polarization suppression can be realized by suppressing the fluctuation.

In the results of analyzing any surface of the silicon nitride sintered compact with X-ray diffraction (XRD), $I_{29.5°}$ is taken as the maximum peak intensity detected at 29.5$\pm$0.3° based on a $REMgSi_2O_5N$ crystal; and $I_{27.0°}$ is taken as the maximum peak intensity detected at 27.0$\pm$0.3° based on a $\beta$-$Si_3N_4$ crystal. In such a case, it is favorable for the peak ratio $(I_{29.5°})/(I_{27.0°})$ to be within the range of not less than 0.01 and not more than 0.15.

When multiple peaks are detected within a range of $\pm$0.3° from a specific angle, the peak at which the intensity of the peak top is a maximum is extracted from the peaks. The intensity of the extracted peak top is used as the maximum peak intensity.

XRD analysis conditions will now be described. In XRD analysis, any cross section of the silicon nitride sintered compact is used as the measurement surface. The surface roughness Ra of the measurement surface is set to be not more than 1 $\mu$m. XRD analysis is performed by using a Cu target (Cu-K$\alpha$) and by setting the tube voltage to 40 kV, the tube current to 40 mA, the scan speed to 2.0°/min, the slit (RS) to 0.15 mm, and the scanning range (2$\theta$) to 10° to 50°.

If the presence of RE, Mg, Si, O, and N is confirmed by composition analysis such as EDS or the like and a peak is detected at 29.5$\pm$0.3°, the peak can be determined to be a peak based on a $REMgSi_2O_5N$ crystal. Similarly, if a peak is detected at 27.0$\pm$0.3° and a peak is detected at 33.6$\pm$0.3°, the peaks can be determined to be based on a $\beta$-$Si_3N_4$ crystal.

Among the peaks based on a $\beta$-$Si_3N_4$ crystal, the intensities of the peak detected at 33.6$\pm$0.3° and the peak detected at 27.0$\pm$0.3° are relatively greater than the intensities of the other peaks. Here, the intensity of the peak detected at 27.0$\pm$0.3° is used to calculate the peak ratios. As a result, the composition of the silicon nitride sintered compact can be evaluated with higher accuracy.

A $REMgSi_2O_5N$ crystalline phase is present in the grain boundary phase. The $REMgSi_2O_5N$ crystalline phase is a component that is effective in controlling the atom ratio Mg/RE to be within the range of not less than 0.01 and not more than 1.5. In other words, the $REMgSi_2O_5N$ crystalline phase is a crystalline phase that is easily formed by setting the atom ratio Mg/RE to be within the range of not less than 0.01 and not more than 1.5. Also, the peak ratio $(I_{29.5°})/(I_{27.0°})$ is an index that indicates the ratio of the $REMgSi_2O_5N$ crystals and the $\beta$-$Si_3N_4$ crystals present. The peak ratio $(I_{29.5°})/(I_{27.0°})$ being not less than 0.01 and not more than 0.15 indicates that the atom ratio of Mg to rare-earth element is controlled in the silicon nitride sintered compact (the $Si_3N_4$ crystal matrix), and that the composition of these elements is controlled as the $REMgSi_2O_5N$ crystalline phase. There is a possibility that compositionally different phases may be formed when the peak ratio $(I_{29.5°})/(I_{27.0°})$ is less than 0.01 or greater than 0.15.

When XRD analysis is performed on any surface of the silicon nitride sintered compact, it is favorable for a peak to be detected at one or both of 27.8$\pm$0.3° and 30.8$\pm$0.3° based on a $REMgSi_2O_5N$ crystal. Furthermore, it is favorable for at least one of the peak ratio $(I_{27.8°})/(I_{27.0°})$ being not less than 0.005 and not more than 0.05 or the peak ratio $(I_{30.5°})/(I_{27.0°})$ being not less than 0.005 and not more than 0.05 to be satisfied, wherein $I_{27.8}$ is the maximum peak intensity detected at 27.8$\pm$0.3°, and $I_{30.8°}$ is the maximum peak intensity detected at 30.8$\pm$0.3°.

If the presence of RE, Mg, Si, O, and N is confirmed by composition analysis such as EDS or the like, and a peak is detected at 27.8$\pm$0.3° or 30.8$\pm$0.3°, the peak may be determined to be based on a $REMgSi_2O_5N$ crystal. $(I_{27.8°})/(I_{27.0°})$ or $(I_{30.8°})/(I_{27.0°})$ being within the range of not less than 0.005 and not more than 0.05 indicates that the atom ratio Mg/RE is controlled in the silicon nitride sintered compact (the $Si_3N_4$ crystal matrix), and that the composition of the elements are controlled as the $REMgSi_2O_5N$ crystalline phase.

One or multiple conditions of the peak ratio $(I_{29.5°})/(I_{27.0°})$, the peak ratio $(I_{27.8°})/(I_{27.0°})$, and the peak ratio $(I_{30.8°})/(I_{27.0°})$ being satisfied indicates that the atom ratio Mg/RE is controlled in the silicon nitride sintered compact (the $Si_3N_4$ crystal matrix), and the composition of the elements is controlled as the $REMgSi_2O_5N$ crystalline phase. It is sufficient for a peak to be detected in at least one of 27.8$\pm$0.3° or 30.8$\pm$0.3° for the range of 27.8$\pm$0.3° and 30.8$\pm$0.3°. It is more favorable for peaks to be detected at both 27.8$\pm$0.3° and 30.8$\pm$0.3°. Also, it is most favorable for all three of the peak ratio $(I_{29.5°})/(I_{27.0°})$, the peak ratio $(I_{27.8°})/(I_{27.0°})$, and the peak ratio $(I_{30.8°})/(I_{27.0°})$ to satisfy the ranges described above.

The heights of the peaks of the XRD analysis change according to the crystal amount and the crystallinity. At least one of the peak ratio $(I_{27.8°})/(I_{27.0°})$ being not less than 0.005 and not more than 0.05 or the peak ratio $(I_{30.8°})/(I_{27.0°})$ being not less than 0.005 and not more than 0.05 being satisfied indicates that many $REMgSi_2O_5N$ crystals are present in the grain boundary phase 4. More favorably, both of the peak ratio $(I_{27.8°})/(I_{27.0°})$ and the peak ratio $(I_{30.8°})/(I_{27.0°})$ are within the range of not less than 0.005 and not more than 0.05. The atom ratio Mg/RE being controlled and the peak ratios being within the ranges described above indicates that the crystalline phases included in the grain boundary phase 4 are homogeneously distributed.

Also, the presence of crystals in the grain boundary phase 4 can improve the thermal conductivity. A crystal compound other than the $REMgSi_2O_5N$ crystal may be present in the grain boundary phase 4. For example, in the grain boundary phase 4 other than the $REMgSi_2O_5N$ crystals, one or more of RE, Mg, Si, O, or N may not be present, and a crystal compound made of other elements may be present. Also, the crystal compound may include elements other than RE, Mg, Si, O, and N as constituent elements. Crystal compounds may be present in which the composition coefficients of RE, Mg, Si, O, and N are different from those of the $REMgSi_2O_5N$ crystals. Whether or not the coefficients are different is determined by rounding the first decimal place to the nearest whole number.

An amorphous phase may be present in the grain boundary phase 4. Amorphous phase refers to a glass phase. An amorphous phase has no crystal structure, and so no peak is detected in XRD analysis. Even if the constituent elements are the same as those of the crystal compound described above, peaks are not detected when the constituent elements are in amorphous phases.

Thus, crystal compounds and/or amorphous phases other than $REMgSi_2O_5N$ crystals may be present in the grain boundary phase 4. It is important to control the ratio of the peaks based on the $REMgSi_2O_5N$ crystal.

The highly thermally-conductive silicon nitride sintered compact may include components other than Mg and rare-earth elements. Examples of components other than Mg and rare-earth elements include at least one selected from Ca (calcium), Hf (hafnium), Ti (titanium), Nb (niobium), Zr (zirconium), W (tungsten), and Mo (molybdenum). These elements are components that reinforce the grain boundary phase. These components are present as simple metals, oxides, or nitrides. There are also components that can react with rare-earth elements to form complex oxides, complex nitrides, and complex oxynitrides.

The grain boundary phase 4 that is present in a 5 $\mu$m$\times$5 $\mu$m measurement area in any cross section may include Hf as an element included in the grain boundary phase 4. When converted into metallic elements, a region in which the atom ratio Hf/RE of Hf to rare-earth element is not less than 0.01 and not more than 1.5 and a region in which the atom ratio Hf/RE is greater than 1.5 may be present in the 5 $\mu$m$\times$5 $\mu$m measurement area.

The grain boundary phase 4 that is present in a 5 $\mu$m$\times$5 $\mu$m measurement area in any cross section may include Zr as an element included in the grain boundary phase 4. When converted into metallic elements, a region in which the atom ratio Zr/RE of Zr to rare-earth element is not less than 0.01 and not more than 1.5 and a region in which the atom ratio Zr/RE is greater than 1.5 may be present in the 5 $\mu$m$\times$5 $\mu$m measurement area.

When the grain boundary phase 4 includes both Hf and Zr, a region in which one of the atom ratio Hf/RE or the atom ratio Zr/RE is not less than 0.01 and not more than 1.5 and a region in which the one of the atom ratio Hf/RE or the atom ratio Zr/RE is greater than 1.5 may be present. A region in which the atom ratio Hf/RE and the atom ratio Zr/RE each are not less than 0.01 and not more than 1.5 and a region in which the atom ratio Hf/RE and the atom ratio Zr/RE each are greater than 1.5 may be present.

Here, in the 5 $\mu$m$\times$5 $\mu$m measurement area, when converted into metallic elements, a region in which the atom ratio Hf/RE is not less than 0.01 and not more than 1.5 is called a "Hf-poor region"; and a region in which the atom ratio Hf/RE is greater than 1.5 is called a "Hf-rich region". In such a case, it is favorable for the ratio of the number of analysis points of Hf-poor regions to the overall number of analysis points to be not less than 0.5 and not more than 1. For example, when the overall number of analysis points is ten locations, and the analysis points are Hf-poor regions at six locations, the ratio (number of analysis points of Hf-poor regions)/(overall number of analysis points) is 0.6 (6/10).

The ratio (number of analysis points of Hf-poor regions)/(overall number of analysis points) being not less than 0.5 and not more than 1 indicates that more Hf-poor regions are present than Hf-rich regions. There are cases where Hf reacts with rare-earth elements and oxygen to form RE-Hf-O-based compounds. Examples of RE-Hf-O-based compounds include $RE_2Hf_2O_7$, etc. Many Hf-poor regions (few Hf-rich regions) can form stable RE-Hf-O-based compounds. Also, sufficient RE for forming $REMgSi_2O_5N$ crystals can be present. As a result, the atom ratio Mg/RE is easily controlled. Also, it is more favorable for no Hf-rich regions to be present.

This is similar for Zr as well. In the 5 $\mu$m$\times$5 $\mu$m measurement area, when converted into metallic elements, a region in which the atom ratio Zr/RE is not less than 0.01 and not more than 1.5 is called a "Zr-poor region"; and a region in which the atom ratio Zr/RE is greater than 1.5 is called a "Zr-rich region". It is favorable for the ratio of the number of analysis points of Zr-poor regions to the overall number of analysis points to be not less than 0.5 and not more than 1. It is more favorable for no Zr-rich regions to be present.

The TEM-EDS described above is used to analyze the Hf-poor regions, the Hf-rich regions, the Zr-poor regions, and the Zr-rich regions. Either point analysis or area analysis may be used. Areas that do not overlap are measured at not less than ten locations. The atom ratio Hf/RE or the atom ratio Zr/RE may be measured together when measuring the atom ratio Mg/RE in the grain boundary phase 4.

It is favorable for the average oxygen amount in the silicon nitride crystal grains 3 to be not more than 0.2 mass%. Oxygen in the silicon nitride crystal grains 3 refers to solid solution oxygen. The thermal conductivity can be increased by reducing the solid solution oxygen amount in the silicon nitride crystal grains 3. Also, $REMgSi_2O_5N$ crystals can be easily formed by controlling the solid solution oxygen amount. The solid solution oxygen amount of the silicon nitride crystal grains 3 is affected by the sintering process. There is a possibility that an increase of the solid solution oxygen amount also may affect the crystallization control of the grain boundary phase 4; and crystal compounds other than $REMgSi_2O_5N$ crystals may be formed.

Although the lower limit of the solid solution oxygen amount is not particularly limited, it is favorable to be not less than 0.01 mass%. When the solid solution oxygen in the silicon nitride crystal grains 3 is less than 0.01 mass%, there is a possibility that the burden on the manufacturing cost may be increased. It is therefore favorable for the average oxygen amount in the silicon nitride crystal grains 3 to be within the range of not less than 0.01 mass% and not more than 0.2 mass%, and more favorably within the range of not less than 0.05 mass% and not more than 0.19 mass%.

The method that uses TEM-EDS described in JP-A 2022-71426 (Kokai) (Patent Literature 4) is used as the method for measuring the solid solution oxygen amount. Not less than one location is used as a measurement region for each silicon nitride crystal grain 3 present in the 5 $\mu$m$\times$5 $\mu$m measurement area. Patent Literature 4 describes TEM-EDS, SIMS, and the total dissolution method as methods for measuring the solid solution oxygen amount. As described in Patent Literature 4, a method that uses TEM-EDS can measure the solid solution oxygen amount of the individual silicon nitride crystal grains 3. According to the method for measuring the solid solution oxygen amount of Patent Literature 4, the solid solution oxygen amount in the silicon nitride crystal grains 3 is calculated using the O/Si atomic ratio. The solid solution oxygen amount is converted into mass% based on the atomic ratio of oxygen to silicon. The O/Si atomic ratio reaches or drops below 0.042 when the solid solution oxygen amount in the silicon nitride crystal grains is not more than 0.2 mass%.

According to the silicon nitride sintered compact described above, the frequency dependence of the relative dielectric constant and the temperature dependence of the relative dielectric constant can be improved. The relative dielectric constant is the value of the dielectric constant of a medium between electrodes divided by the dielectric constant of a vacuum. Here, the medium is the silicon nitride sintered compact. The silicon nitride sintered compact is both an insulator and a dielectric. The electric field causes polarization in the silicon nitride sintered compact. The relative dielectric constant of the medium increases as the polarization of the medium increases.

It was found that the atom ratio Mg/RE in the grain boundary phase 4 and/or the solid solution oxygen amount of the silicon nitride crystal grains 3 affect the frequency dependence of the relative dielectric constant and/or the temperature dependence of the relative dielectric constant. When the relative dielectric constant of the medium is high, polarization easily occurs, which may cause degradation of the insulative properties. As described above, the characteristics of the relative dielectric constant can be improved by controlling the atom ratio Mg/RE in the grain boundary phase 4 or the solid solution oxygen amount in the silicon nitride crystal grains 3.

According to the silicon nitride sintered compact according to the embodiment, the relative dielectric constant at 50 Hz and room temperature can be set to be not more than 10. Room temperature is 25 °C. According to the silicon nitride sintered compact, the relative dielectric constant at 50 Hz and room temperature also can be set to be not more than 9.0.

Furthermore, $\varepsilon_{50\text{-}300}/\varepsilon_{50\text{-}25}$ can be set to be within the range of not less than 0.95 and not more than 1.09, wherein $\varepsilon_{50\text{-}25}$ is the relative dielectric constant at 50 Hz and room temperature, and $\varepsilon_{50\text{-}300}$ is the relative dielectric constant at 50 Hz and 300 °C.

It is favorable for $\varepsilon_{1M\text{-}300}/\varepsilon_{1M\text{-}25}$ to be within the range of not less than 0.95 and not more than 1.09, wherein $\varepsilon_{1M\text{-}25}$ is the relative dielectric constant at 1 MHz and room temperature, and $\varepsilon_{1M\text{-}300}$ is the relative dielectric constant at 1 MHz and 300 °C. It is favorable for $\varepsilon_{1M\text{-}300}/\varepsilon_{50\text{-}300}$ to be within the range of not less than 0.95 and not more than 1.09.

It is favorable for $\varepsilon_{10M\text{-}25}$ to be not more than 9.0, wherein $\varepsilon_{10M\text{-}25}$ is the relative dielectric constant at 10 MHz and room temperature. It is favorable for $\varepsilon_{10M\text{-}25}/\varepsilon_{1M\text{-}25}$ to be within the range of not less than 0.95 and not more than 1.09.

The relative dielectric constant is measured in accordance with JIS-C-2141 (1992). The relative dielectric constant is measured using the formula (relative dielectric constant $\varepsilon_r = C_x/C_0$) shown in "16.4 Calculation" of JIS-C-2141. $C_x$ is the electrostatic capacitance value of the major electrode. $C_0$ is the electrostatic capacitance value when the relative dielectric constant $\varepsilon$ calculated based on the area of the major electrode and the thickness of the test piece is equal to 1. JIS-C-2141 corresponds to ISO 672-2.

Specifically, first, a plate-shaped silicon nitride sintered compact is prepared. The silicon nitride sintered compact is rectangular with each side being not less than 50 mm, or circular with a diameter of not less than 50 mm. A major electrode is located at one surface of the silicon nitride sintered compact; and guard electrodes are located around the major electrode. The major electrode also is called the upper electrode. A lower electrode is located at the other surface of the silicon nitride sintered compact. The electrostatic capacitance of the major electrode is measured while applying a voltage between the major electrode and the lower electrode at a frequency of 50 Hz, 1 MHz, or 10 MHz. The measurement frequency tolerance is $\pm$20%; and the measurement voltage is not more than 5 Vrms. The relative dielectric constant of the silicon nitride sintered compact is calculated based on the measured electrostatic capacitance of the major electrode, the electrostatic capacitance when the relative dielectric constant $\varepsilon$ = 1, the diameters of the electrodes, the gap between the major electrode and the guard electrode, the thickness of the silicon nitride sintered compact, etc.

According to the silicon nitride sintered compact according to the embodiment, the relative dielectric constant at 50 Hz and room temperature can be 10 or less. The relative dielectric constant at 50 Hz and room temperature being not more than 10 indicates that the polarization of the silicon nitride sintered compact can be suppressed with these conditions. That is, this indicates that the insulative properties of the silicon nitride sintered compact are high. Therefore, the reliability of a semiconductor device in which a semiconductor element is mounted can be increased.

$\varepsilon_{50-300}/\varepsilon_{50-25}$ being within the range of not less than 0.95 and not more than 1.09 indicates that the change of the relative dielectric constant at 50 Hz is small, even when the temperature changes. That is, this indicates that the temperature dependence of the relative dielectric constant at 50 Hz is small. Therefore, even when the guaranteed operating temperature of the semiconductor element is increased, the characteristics that are dependent on the relative dielectric constant do not degrade easily.

$\varepsilon_{1M-300}/\varepsilon_{1M-25}$ being within the range of not less than 0.95 and not more than 1.09 indicates that the change of the relative dielectric constant at 1 MHz is small, even when the temperature changes. That is, this indicates that the temperature dependence of the relative dielectric constant at 1 MHz is small. Therefore, even when the guaranteed operating temperature of the semiconductor element is increased, the characteristics that are dependent on the relative dielectric constant do not degrade easily.

$\varepsilon_{1M-300}/\varepsilon_{50-300}$ being not less than 0.95 and not more than 1.09 indicates that the change of the relative dielectric constant is small, even when the frequency changes. That is, the characteristics that are dependent on the relative dielectric constant do not degrade easily, even when the operating frequency of the semiconductor element changes. As long as $\varepsilon_{10M-25}/\varepsilon_{1M-25}$ is within the range of not less than 0.95 and not more than 1.09, the characteristics that are dependent on the relative dielectric constant do not degrade easily, even when the operating frequency of the semiconductor element is further increased.

Favorably, $\varepsilon_{50-300}/\varepsilon_{50-25}$, $\varepsilon_{1M-300}/\varepsilon_{1M-25}$, $\varepsilon_{1M-300}/\varepsilon_{50-300}$, and $\varepsilon_{10M-25}/\varepsilon_{1M-25}$ each are within the ranges described above.

According to the silicon nitride sintered compact according to the embodiment, the relative dielectric constant at frequencies greater than 1 MHz also can be more stable. For example, the relative dielectric constant 10MH and at room temperature is taken as $\varepsilon_{10M-25}$. Also, it is favorable for $\varepsilon_{10M-25}/\varepsilon_{1M-25}$ to be within the range of not less than 0.95 and not more than 1.09. By controlling the mass ratio Mg/RE of the grain boundary phase 4 and the solid solution oxygen amount in the silicon nitride crystal grains 3, the characteristics of the relative dielectric constant can be improved, even when the frequency is greater than 1 MHz.

The operating frequencies of semiconductor elements range widely from several tens of Hz to 1 MHz. The operating frequency of a GaN device may be greater than 1 MHz. Semiconductor elements include bipolar transistors, MOSFETs, IGBTs, GTOs, etc. Such semiconductor elements are called power semiconductors. Power semiconductors can be switched on and off according to the operating frequency. Each semiconductor element has a different operating frequency range. By improving the temperature dependence and frequency dependence of the relative dielectric constant of the silicon nitride sintered compact, the insulative properties can be maintained no matter what semiconductor element is mounted. As a result, a semiconductor device that has high reliability can be provided.

Accordingly, the silicon nitride sintered compact according to the embodiment is favorable for silicon nitride substrates. It is favorable for the thickness of the substrate to be not less than 0.1 mm and not more than 3 mm. Even if the thickness of the silicon nitride substrate is reduced to be not less than 0.1 mm and not more than 3 mm, the reliability is high because the relative dielectric constant is improved. It is more favorable for the thickness of the substrate to be within the range of not less than 0.1 mm and not more than 0.4 mm. Reducing the thickness of the substrate has the effect of lowering the thermal resistance. Therefore, the heat dissipation is improved.

The fracture toughness value of the silicon nitride sintered compact can be set to be not less than 6.0 MPa·m$^{1/2}$, and the three-point bending strength can be set to be not less than 500 MPa. Therefore, the thermal conductivity and the insulative properties can be improved while maintaining the strength. Fracture toughness values are measured using the IF method in accordance with JIS-R-1607 (2015) and are calculated using Niihara's equation. The three-point bending strength is measured using a method in accordance with JIS-R-1601 (2008). JIS-R-1607 corresponds to ISO 15732. Also, JIS-R-1601 corresponds to ISO 14704.

Silicon nitride substrates are favorable for silicon nitride circuit boards that include circuit parts. Silicon nitride circuit boards are favorable for semiconductor devices on which semiconductor elements are mounted. FIG. 4 shows an example of a silicon nitride circuit board. In FIG. 4, reference numeral 1 is a silicon nitride substrate, reference numeral 5 is a circuit part (a metal plate), reference numeral 6 is a heat dissipation plate, reference numeral 7 is a bonding layer, and reference numeral 10 is a silicon nitride circuit board. FIG. 5 shows an example of a semiconductor device. In FIG. 5, reference numeral 8 is a semiconductor element, reference numeral 10 is a silicon nitride circuit board, and reference numeral 20 is a semiconductor device.

The circuit part 5 has a circuit configuration. The circuit part 5 is used as a location to mount a semiconductor element, etc. FIG. 4 shows an example in which the circuit part 5 is formed of a metal plate. Also, although FIG. 4 shows an example in which two circuit parts 5 are provided, the number of the circuit parts 5 is arbitrary. The heat dissipation plate 6 is located at the side opposite to the circuit part 5. The heat dissipation plate 6 may be used as a circuit part as necessary.

Various metal members such as metal plates, metalized layers, thin films, etc., are applicable to the circuit part 5 and the heat dissipation plate 6. Examples of the metal plate include a copper plate, a copper alloy plate, an aluminum plate, an aluminum alloy plate, etc. It is favorable for the metal plate to be a copper plate made of oxygen-free copper. Oxygen-free copper is copper having a copper purity of not less than 99.96 wt% as indicated in JIS-H-3100 (ISO 1337, etc.). The thermal conductivity of a copper plate is about 400 W/m·K, which is greater than the thermal conductivity of aluminum, which is about 240 W/m·K. Therefore, the use of a copper plate can improve the heat dissipation.

It is favorable for the thickness of the metal plate to be within the range of not less than 0.2 mm and not more than 5 mm. By making the metal plate thicker, the heat dissipation can be improved and the current-carrying capacity can be increased. The bonding layer 7 is located between the silicon nitride substrate 1 and the circuit part 5 and between the silicon nitride substrate 1 and the heat dissipation plate 6. Examples of the bonding layer 7 include an active metal bonding layer. When a copper plate is used as the metal plate, an active metal bonding layer that includes Ag or Cu as a major component and includes Ti is used. When an aluminum plate is used as the metal plate, an active metal bonding layer that includes Al as a major component and includes Si is used. The active metal bonding layer refers to a bonding layer that includes Ti or Si as an active metal. Although an example in which a metal plate is bonded is shown as a circuit part, the form of the circuit part is not limited to the example. For example, a metalized layer or a thin film that is formed at the surface of the silicon nitride substrate 1 may be patterned into a circuit configuration.

Thin films refer to metal films formed by a film formation method such as sputtering, vapor deposition, etc. Examples of the metal thin film include thin films of Ti, Pt, Au, Ni, Cu, Al, Ag, etc. Metalized layers are films formed by firing metal pastes. Metallized films are also called metal thick films. Examples of metalized layers include layers of metals such as Ag, Cu, Ti, W, Mo, etc.

The semiconductor device 20 includes the silicon nitride circuit board 10, and the semiconductor element 8 that is mounted to the circuit part 5. One semiconductor element 8 is mounted in the example shown in FIG. 5. The semiconductor element 8 is not limited to the example; and multiple semiconductor elements 8 may be mounted. A leadframe, wire bonding, mold resin, etc., which are not illustrated, may be included as necessary.

A method for manufacturing the highly thermally-conductive silicon nitride sintered compact according to the embodiment will now be described. The manufacturing method is not particularly limited as long as the silicon nitride sintered compact has the characteristics described above. Here, a method for obtaining the silicon nitride sintered compact with a high yield will be described.

First, a silicon nitride powder is prepared. It is favorable for the average particle size of the silicon nitride powder to be not more than 2.5 μm, and for the impurity oxygen content to be not more than 2 mass%. The silicon nitride powder includes impurity oxygen dissolved in the powder and impurity oxygen adhered to the powder surface. The oxygen amount that is dissolved in the silicon nitride grains of the silicon nitride sintered compact can be reduced as the impurity oxygen decreases. It is therefore favorable for the impurity oxygen amount of the silicon nitride powder to be not more than 2 mass%, and more favorably not more than 1 mass%.

Silicon nitride powders are mainly manufactured by imide decomposition or direct nitriding. A silicon nitride powder that is manufactured by imide decomposition is more favorable because the impurity oxygen amount dissolved in the powder is low. There are α-type and β-type silicon nitride powders. A β-type silicon nitride powder can have low solid solution oxygen in the crystal structure. On the other hand, an α-silicon nitride powder is easily densified because the sinterability is greater than that of a β-silicon nitride powder. A silicon nitride sintered compact that has high strength can be obtained by using an α-silicon nitride powder as the raw material powder.

A silicon nitride powder may be used in which an α-silicon nitride powder and a β-silicon nitride powder are mixed. When the total of the α-silicon nitride powder and the β-silicon nitride powder is taken as 100 parts by mass, it is favorable for the ratio of the β-silicon nitride powder to be within the range of not less than 1 part by mass and not more than 30 parts by mass. There is a possibility that the sinterability may degrade when the ratio of the β-silicon nitride powder is greater than 30 parts by mass. There is a possibility that the effect of using the β-silicon nitride powder may be insufficient when the ratio of the β-silicon nitride powder is less than 1 part by mass.

Commercially available α-silicon nitride powders have an alpha percentage of not less than 90 wt%. That is, a small amount of a β-silicon nitride powder is unavoidably included in a commercially available α-silicon nitride powder. A raw material powder in which an α-silicon nitride powder and a β-silicon nitride powder are mixed refers to a material in which a β-silicon nitride powder is actively added to the commercially available α-silicon nitride powder. In other words, when only an α-silicon nitride powder that unavoidably includes a β-silicon nitride powder is used, such a powder is not included in "a raw material powder in which an α-silicon nitride powder and a β-silicon nitride powder are mixed".

Also, it is effective to perform treatment to reduce the impurity oxygen of the silicon nitride powder. Examples of the treatment to reduce the impurity oxygen include reduction treatment, chemical treatment, etc. Examples of reduction treatment include heat treatment in a hydrogen atmosphere, heat treatment with carbon present, etc. Examples of heat treatment in which carbon is present include heat treatment in a carbon atmosphere. A carbon atmosphere is an atmosphere that includes carbon and/or carbon monoxide (CO) gas. It is also effective to use a carbon powder and/or a carbon container in the heat treatment. Chemical treatment is a method of treating the silicon nitride powder in an acidic or alkaline solution.

Then, a sintering aid is prepared. The sintering aid promotes sintering, and is a component that becomes the grain boundary phase. At least one selected from a Group 2A element, a Group 3A element, and a Group 4A element is favorable in the sintering aid. The notations of "Group 2A", "Group 3A", and "Group 4A" are based on the Japanese periodic table. It is favorable for the sintering aid to include at least one selected from rare-earth element, magnesium, titanium, and hafnium. It is favorable to add such a sintering aid as an oxide powder. Oxides can form stable grain boundary phases by reacting with each other.

$MgSiN_2$ may be used as the magnesium component. Even when $MgSiN_2$ is used, effects similar to those when MgO is used are obtained. Comparing MgO and $MgSiN_2$, it is more favorable to use MgO. As described above, when two or more types of sintering aids are used, a stable grain boundary phase can be formed better by allowing the oxides to react with each other. That is, the use of MgO can suppress the formation of different phases.

Titanium is present as titanium nitride (TiN) grains in the grain boundary phase. Titanium nitride grains have the effect of reinforcing the grain boundary phase due to a pinning effect. It is favorable for the sintering aid to be a metal oxide powder having an average particle size of not more than 3 $\mu$m. The pinning effect can suppress the grain growth of the silicon nitride crystal grains by, for example, the presence of titanium nitride grains in the grain boundary phase at triple points. This is effective for increasing strength, etc., because the formation of coarse grains can be suppressed.

When the total of silicon nitride and the sintering aid is taken as 100 mass%, it is favorable for the added amount of the sintering aid to be within the range of not less than 1 mass% and not more than 20 mass%. More favorably, the added amount of the sintering aid is within the range of not less than 3 mass% and not more than 15 mass%.

A ball mill and/or a bead mill is used in the mixing process. It is common for the silicon nitride powder and/or the sintering aid powder to be present as agglomerated secondary particles. The secondary particles are an obstructive factor of homogeneous sinterability. The homogeneity of the sinterability can be improved by uniformly mixing secondary particles while pulverizing the secondary particles into primary particles without agglomeration. In the mixing process that accompanies the pulverizing, it is favorable to apply a stress not so high as to further fracture the primary particles. Fracture surfaces are formed in the silicon nitride powder when the primary particles are fractured. Fracture surfaces are active surfaces. Therefore, an oxide film is formed for stabilization, and the oxygen adhesion amount increases. The adhered oxygen amount undesirably increases compared to the primary particles. Accordingly, it is effective to suppress formation of fracture surfaces in the primary particles to reduce the solid solution oxygen amount of the silicon nitride crystal grains.

Wet pulverization that uses a solvent is suited to such pulverization of the secondary particles. A solvent that has high wettability to the particle surface and low reactivity with the particles is used. As a result, low stress is necessary for the pulverization, and fracture of the primary particles can be suppressed. An organic solvent is suited to the mixing that accompanies the pulverization of the silicon nitride powder and the sintering aid powder. Alcohols and ketones are suited to the organic solvent. An organic solvent that is a mixture of an alcohol and a ketone may be used.

Alcohol is a general term for a substance in which a portion of the hydrogen included in a hydrocarbon is replaced with a hydroxyl group (OH group). Ketones are substances represented by R-C(=O)-R'. R and R' are alkyl groups, etc. These organic solvents have high wettability to the silicon nitride powder and the sintering aid powder and low reactivity with the powders. It is common to add the sintering aid powder as an oxide powder. It is desirable to use a mixture of an alcohol and a ketone in a raw material composition in which a silicon nitride powder and an oxide powder are mixed. A dispersant may be added as necessary. The dispersant has the effect of stabilizing the primary particles in the solvent, and suppresses re-agglomeration. A surfactant or the like is used as the dispersant.

It is favorable for the diameter of the media when performing the pulverizing process by ball milling to be not more than 20 mm, and more favorably not more than 12 mm. The media is a ceramic ball. Ball milling is a method in which the powder and the media are placed in a cylindrical container and the powder is pulverized while rotating the cylindrical container. A ball mill process that uses an organic solvent as described above is wet pulverization and mixing. The stress that is necessary for pulverization can be reduced by selecting an organic solvent suited to the powder. That is, the organic solvent makes it possible to pulverize a ceramic ball having a small media diameter, and has the effect of reducing the energy of the media impacting the powder. By reducing the energy of the media impacting the powder, the formation of fracture surfaces in the primary particles can be suppressed. It is favorable for the minimum value of the diameter of the media to be not less than 3 mm. When the media is too small, there is a possibility that the work efficiency may decrease.

It is favorable for the wet pulverization and mixing by ball milling to be within the range of not less than 5 hours and not more than 40 hours. When less than 5 hours, there is a possibility that the effects of the pulverization may be insufficient, and many secondary particles may remain. When the wet pulverization and mixing is greater than 40 hours, the likelihood of fracture surfaces forming in the primary particles increases. It is therefore favorable for the wet pulverization and mixing by ball milling to be within the range of not less than 5 hours and not more than 40 hours, and more favorably within the range of not less than 10 hours and not more than 30 hours. Also, it is favorable for the rotational speed of the cylindrical container in the ball mill process to be within the range of not less than 50 rpm and not more than 500 rpm.

The pulverization of the secondary particles can be ascertained by checking the particle size distribution before and after pulverizing. As the secondary particles are pulverized and primary particles increase, the peak position of the particle size distribution (the frequency distribution) shifts toward a smaller particle size. Also, the peak of the particle size distribution has a sharper shape.

The suppression of the fracture surfaces of the primary particles can be ascertained by measuring the oxygen amount before and after pulverizing. The oxygen amount before pulverizing is the oxygen amount of the raw material powder. The oxygen amount of the raw material powder after pulverizing not increasing drastically compared to before pulverizing indicates that the formation of the fracture surfaces of the primary particles is suppressed.

A raw material powder slurry is obtained by performing a wet pulverization and mixing process. Then, a forming process is performed to form a compact using the raw material powder slurry. Examples of the molding process include sheet molding, die molding, etc. Sheet molding is a doctor blade technique or the like. When sheet molding is performed, cutting that cuts an elongated sheet into the necessary size is performed. The slurry may be used after being processed into a granulated powder or the like suited to the molding method.

Also, it is favorable to control the thixotropy of the raw material powder slurry. Thixotropy refers to the time-dependent flow characteristics of a non-Newtonian slurry. Time-dependent flow characteristics are properties in which the apparent viscosity decreases with time at a constant shear rate and gradually recovers when the force is removed. The thixotropy is considered to reflect the internal structure of the fluid such as whether or not the slurry particles are agglomerated. JIS-R-1665 (2005) defines the evaluation of thixotropy by using hysteresis measurements of flow curves.

Thixotropy is indicated by the thixotropic index (TI index). The TI index is measured using a rotational viscometer in accordance with JIS-R-1665. For a fluid that has cohesion, the viscosity generally decreases as the shear rate is continuously increased by the rotational viscometer. At this time, the ratio of a viscosity $\eta$ at a shear rate b to a viscosity $\eta$ at a shear rate b is used as the TI index. In other words, the TI index is represented by the following formula.

$$\text{TI index} = \eta a / \eta b$$

The measurement is performed with the shear rate a set to 4 ($s^{-1}$) and the shear rate b set to 40 ($s^{-1}$). s is seconds. As the TI index approaches 1, the behavior of the raw material powder slurry approaches a Newtonian fluid. That is, the TI index approaching 1 means a highly dispersed slurry with no cohesion or with extremely weak cohesion.

It is favorable for the TI index of the raw material powder slurry to be within the range of not less than 1 and not more than 2. To set the TI index within the range of not less than 1 and not more than 2, it is effective to suppress cohesion at the slurry stage. As a result, the Mg distribution and the rare-earth element distribution in the grain boundary phase can be stabilized.

Then, a degreasing process of the obtained compact is performed. It is favorable to perform the degreasing process within the range of not less than 400 °C and not more than 800 °C. Organic substances in the compact can be removed by performing the degreasing process. A compact on which the degreasing process has been performed is called a degreased body.

Then, a sintering process of sintering the degreased body is performed. It is favorable for the sintering process to include a first holding process within the range of not less than 1,500 °C and not more than 1,650 °C and a second holding process within the range of not less than 1,750 °C and not more than 2,000 °C.

The first holding process is a process of holding the degreased body within the range of not less than 1,500 °C and not more than 1,650 °C. It is favorable for the holding time to be not less than 2 hours. The temperature range of not less than 1,500 °C and not more than 1,650 °C corresponds to the temperature range in which grain growth of silicon nitride starts. Also, the temperature range of not less than 1,500 °C and not more than 1,650 °C corresponds to the temperature at which the impurity oxygen starts to desorb from the silicon nitride powder. The impurity oxygen desorbs as SiO (silicon monoxide). By performing the first holding process, the solid solution oxygen amount in the silicon nitride powder can be efficiently reduced. Then, the grain growth of the silicon nitride crystal grains can be homogenized.

It is favorable for the upper limit of the holding time in the first holding process to be not more than 10 hours. When greater than 10 hours, there is a possibility that the oxygen necessary for liquid phase formation which occurs with the sintering aid may be insufficient, and the sinterability may degrade. It is therefore favorable for the holding time of the first holding process to be within the range of not less than 2 hours and not more than 10 hours, and more favorably within the range of not less than 3 hours and not more than 6 hours. It is favorable to perform the holding process at atmospheric pressure (= 0.1 MPa) or in a reduced-pressure atmosphere that is less than atmospheric pressure. In a so-called pressurized atmosphere that is greater than 0.1 MPa, there is a tendency for SiO desorption to be suppressed.

The second holding process is a process of holding the degreased body within the range of not less than 1,750 °C and not more than 2,000 °C. The holding temperature of the second holding process corresponds to the so-called sintering temperature. The sintered compact can be densified in this temperature range. Also, the major diameter and/or aspect ratio of the silicon nitride crystal grains can be controlled. When the holding temperature is less than 1,750 °C, there is a possibility that the densification may be insufficient. When the holding temperature is greater than 2,000 °C, there is a possibility that grain growth of the silicon nitride crystal grains may be excessive.

It is favorable for the holding time of the second holding process to be within the range of not less than 5 hours and not more than 30 hours. It is favorable to perform the second holding process in a pressurized atmosphere of not less than 0.5 MPa. In a pressure atmosphere at or less than 0.1 MPa (atmospheric pressure), there is a possibility that densification may be insufficient because self-decomposition of silicon nitride easily occurs at 1,700 °C or more.

It is favorable to perform the sintering process in a nonoxidizing atmosphere. Examples of the nonoxidizing atmosphere include a nitrogen atmosphere, an argon atmosphere, and a vacuum atmosphere. By using a nonoxidizing atmosphere, the oxygen dissolved in the silicon nitride crystal grains can be suppressed.

It is favorable to control the sintering atmosphere when performing the first holding process and the second holding process. To control the sintering atmosphere, it is effective to provide a packing powder inside the sintering chamber. As described above, the first holding process and the second holding process are at high temperatures. There are cases where partitions of the firing chamber have a double structure to control the temperature. The degreased body also may be sintered by storing in a firing container. Packing powder is a powder that is placed between the partitions of the firing chamber or between the partition and the firing container.

The packing powder may be placed on or around the firing container. The placement of the packing powder can suppress effects of the firing atmosphere on the characteristics of the silicon nitride sintered compact. It is unnecessary to form a completely sealed space at the exterior wall, interior wall, or firing container in the firing chamber. Gases emitted from the degreased body may be exhausted outside from the exterior wall, interior wall, or firing container. As described above, SiO (silicon monoxide) is desorbed from the degreased body in the sintering process. Desorption of gas components other than SiO also occurs in the sintering process. By using the packing powder, unfavorable effects of the desorbed gas component on the silicon nitride sintered compact can be suppressed. As a result, the atom ratio Mg/RE can be controlled, and the $REMgSi_2O_5N$ crystals can be controlled.

It is favorable for the packing powder to be at least one selected from silicon nitride, silicon oxide, magnesium oxide, and talc. Multiple types of packing powders may be mixed and used. The silicon nitride powder may be either the α-type or the β-type. Talc is a complex oxide represented by $MgO \cdot SiO_2$. These packing powders are effective for controlling the partial pressure in the firing process. Silicon nitride, silicon oxide, magnesium oxide, and talc thermally decompose to generate SiO gas, MgO gas, or Mg gas according to the component. By increasing the partial pressures of the gases, thermal decomposition of the components included in the silicon nitride sintered compact is suppressed. For example, when a silicon nitride powder is included in the packing powder, SiO gas is exhausted from the packing powder. The partial pressure of the SiO gas inside the firing chamber is increased by the SiO gas released from the packing powder. As a result, the components that are included in the silicon nitride sintered compact can be prevented from thermally decomposing and being released as SiO.

A sintered compact can be obtained by performing the sintering process. Reheat treatment may be performed on the sintered compact. In the reheat treatment, a process of holding within the range of not less than 1,400 °C and not more than 1,600 °C is performed. The reheat treatment can effectively promote further desorption of SiO. The sintered compact has a form in which a stable crystal structure is maintained, and so unfavorable effects of the reheat treatment on the crystal structure due to SiO desorption are small. It is favorable for the holding time of the reheat treatment to be not less than 2 hours. It is favorable to perform the reheat treatment at atmospheric pressure (= 0.1 MPa) or in a reduced-pressure atmosphere that is less than atmospheric pressure. In a so-called pressurized atmosphere that is greater than 0.1 MPa, there is a tendency for SiO desorption to be suppressed. Also, similarly to the sintering process, it is favorable to control the atmosphere with a packing powder.

It is good to perform the reheat treatment after cooling the sintered compact to room temperature after the second holding process. The sintered compact may be treated after the second holding process by lowering the temperature and holding at not more than 1,300 °C, and then again raising the temperature of the sintered compact. Being not more than 1,300 °C means a temperature at which the liquid phase made from sintering aids and the like solidifies and no longer contributes to the sintering reaction. In other words, the sintered compact is considered to have a form in which a stable crystal structure is maintained, similarly to being returned to room temperature. Therefore, unfavorable effects of the reheat treatment on the crystal structure due to SiO desorption can be small.

The maximum holding temperature of the reheat treatment is set to be lower than the maximum holding temperature of the second holding process of the sintering. It is favorable for the difference between the maximum holding temperature of the reheat treatment and the maximum holding temperature of the second holding process to be not less than 50 °C and not more than 300 °C. For example, when the maximum holding temperature of the second holding process is 1,800 °C, it is favorable for the maximum holding temperature of the reheat treatment to be within the range of not less than 1,500 °C and not more than 1,750 °C. The reheat treatment has the effects of not only desorbing the oxygen in the sintered compact as SiO out of the sintered compact, but also of suppressing the fluctuation of the solid solution oxygen amount between the silicon nitride crystal grains 3. Also, the grain growth of the silicon nitride crystal grains can be suppressed by setting the maximum holding temperature of the reheat treatment to be less than the holding temperature of the second holding process of the sintering.

It is favorable to perform the reheat treatment in a nonoxidizing atmosphere. By performing in a nonoxidizing atmosphere, the incorporation of oxygen into the silicon nitride crystal grains can be suppressed. A packing powder may be used in the reheat treatment process. It is favorable for the packing powder to be at least one selected from silicon nitride, silicon oxide, magnesium oxide, and talc.

A highly thermally-conductive silicon nitride sintered compact can be manufactured by the processes described above. Also, a silicon nitride substrate can be obtained by patterning the highly thermally-conductive silicon nitride sintered compact into a substrate shape. A silicon nitride circuit board can be obtained by providing a circuit part on the silicon nitride substrate. A semiconductor device can be obtained by mounting a semiconductor element to the circuit part of the silicon nitride circuit board.

(Examples)

(Examples 1 to 8 and Comparative Examples 1 to 4)

Raw material powders of the silicon nitride sintered compacts listed in Table 1 were prepared. In Table 1, the added amounts of the sintering aids are shown in parentheses. The added amounts were the values when the total of silicon nitride and the sintering aid was taken as 100 mass%.

[Table 1]

|  | Sintering aid added amount (mass%) |
| --- | --- |
| Example 1 | $Y_2O_3(10)$-MgO(0.5) |
| Example 2 | $Y_2O_3(5)$-MgO(1) |
| Example 3 | $Er_2O_3(5)$-MgO(2)-$HfO_2(1)$ |
| Example 4 | $Er_2O_3(2)$-MgO(2)-$ZrO_2(2)$ |
| Example 5 | $Y_2O_3(2)$-MgO(3) |
| Example 6 | $Y_2O_3(1)$-MgO(2)-$ZrO_2(2)$ |
| Example 7 | $Yb_2O_3(1)$-MgO(2.5)-$HfO_2(1)$ |
| Example 8 | $Er_2O_3(5)$-$MgSiN_2(4)$-$HfO_2(1)$ |
| Comparative Example 1 | $Y_2O_3(4)$-MgO(4) |
| Comparative Example 2 | $Y_2O_3(2)$-MgO(4) |
| Comparative Example 3 | $Y_2O_3(1)$-MgO(6)-$ZrO_2(1)$ |
| Comparative Example 4 | $Y_2O_3(2)$-MgO(3) |

A raw material powder slurry was prepared by mixing a raw material powder, a binder, and a solvent. A ball mill was used to prepare the raw material powder slurry. The rotational speed of the cylindrical container of the ball mill was set to be within the range of not less than 50 rpm and not more than 150 rpm. The conditions of the ball mill were as shown in Table 2. Also, the TI index of the obtained raw material powder slurry was measured. The method for measuring the TI index was as described above.

[Table 2]

|  | Wet pulverization and mixing process | | | TI index |
| --- | --- | --- | --- | --- |
|  | Solvent | Media diameter (mm) | Time (h) | |
| Example 1 | Ethanol | 10 | 20 | 1.8 |
| Example 2 | Methyl ethyl ketone | 10 | 25 | 1.2 |
| Example 3 | Propanol | 10 | 20 | 1.5 |
| Example 4 | Propanol+Methyl ethyl ketone | 20 | 15 | 1.7 |
| Example 5 | Ethanol | 30 | 20 | 2.0 |
| Example 6 | Ethanol | 10 | 25 | 1.5 |
| Example 7 | Ethanol | 10 | 25 | 1.5 |
| Example 8 | Ethanol+ Methyl ethyl ketone | 20 | 15 | 1.8 |

(continued)

| | Wet pulverization and mixing process | | | TI index |
| --- | --- | --- | --- | --- |
| | Solvent | Media diameter (mm) | Time (h) | |
| Comparative Example 1 | Ethanol | 30 | 20 | 2.6 |
| Comparative Example 2 | Water | 30 | 20 | 2.3 |
| Comparative Example 3 | None (dry mixing) | 30 | 20 | 3.4 |
| Comparative Example 4 | Ethanol | 30 | 10 | 2.8 |

The method for preparing the raw material powder slurries of the examples satisfied favorable manufacturing conditions. The TI indexes of the raw material powder slurries of the examples were within the range of not less than 1 and not more than 2. In contrast, according to the comparative examples, favorable manufacturing conditions were not satisfied. Therefore, the TI indexes of the raw material powder slurries were greater than 2.

Sheet molding by the doctor blade technique was performed using the raw material powder slurry. The obtained sheet compact was cut into a prescribed size. A degreased body was made by performing a degreasing process on the sheet compact. The degreasing process was performed within the range of not less than 400 °C and not more than 800 °C.

A sintering process was performed on the obtained degreased body. The conditions of the sintering process were as shown in Table 3. Specifically, the first holding process in which the degreased body was held within the range of 1,500 to 1,650 °C was performed for Examples 1 to 8, and the first holding process was not performed for Comparative Examples 1 to 4. The holding temperature, whether or not the pressure was not less than 0.5 MPa, whether or not a packing powder was used, and the components of the packing powder when used are shown in Table 3 for the second holding process. Also, whether or not reheat treatment was performed, whether or not a packing powder was used in the reheat treatment, and the components of the packing powder when used are shown in Table 3.

[Table 3]

| | Sintering process | | | | Reheat treatment | |
| --- | --- | --- | --- | --- | --- | --- |
| | First holding process | Second holding process | | | 1400-1600°C | Packing powder |
| | Hold at 1,500 to 1,650°C | Holding temperature | Pressure not less than 0.5 MPa | Packing powder | | |
| Example 1 | Yes | 1800 | Yes | Silicon nitride MgO | Yes | No |
| Example 2 | Yes | 1850 | Yes | MgO | Yes | MgO |
| Example 3 | Yes | 1900 | Yes | MgO | Yes | MgO |
| Example 4 | Yes | 1950 | Yes | MgO | Yes | No |
| Example 5 | Yes | 1900 | Yes | Talc | Yes | No |
| Example 6 | Yes | 1850 | Yes | $SiO_2$ | Yes | No |
| Example 7 | Yes | 1900 | Yes | Silicon nitride Talc | Yes | Silicon nitride Talc |
| Example 8 | Yes | 1950 | Yes | MgO | Yes | MgO |
| Comparative Example 1 | No | 1900 | Yes | None | No | No |
| Comparative Example 2 | No | 1950 | Yes | None | No | No |
| Comparative Example 3 | No | 1850 | Yes | None | No | No |
| Comparative Example 4 | No | 1900 | Yes | None | No | No |

The silicon nitride substrates according to the examples and the comparative examples were made by the processes described above. The atom ratios Mg/RE of the silicon nitride substrates were measured. The atom ratio Hf/RE or the atom ratio Zr/RE was measured for Examples 3, 4, 6, and 7 and Comparative Example 3 to which a Hf component or a Zr component was added. Table 4 shows the measurement results.

Arbitrary cross sections were analyzed by TEM-EDS to measure the atom ratio. The TEM-EDS conditions were as described above. First, a first measurement area of a 5 μm×5 μm measurement area was set. Then, second to fifth measurement areas were set respectively in the areas above, below, leftward, and rightward around the first measurement area. It was confirmed for each of the first to fifth measurement areas whether or not the grain boundary phase was present at an area ratio of not less than 10%. When the grain boundary phase had an area ratio of less than 10% in any of the measurement areas, the first to fifth measurement areas were reset at another location. After the first to fifth measurement areas were determined, the atom ratio Mg/RE was measured for the individual grain boundary phases 4 present in the measurement areas. The average value of the atom ratio Mg/RE was calculated for each measurement area. As a result, five atom ratios Mg/RE that typify the measurement areas were obtained. Table 4 shows the minimum value and maximum value of the five atom ratios Mg/RE. Also, the atom ratios Mg/RE between the measurement areas that were adjacent to each other were calculated. That is, the atom ratio Mg/RE differences between the first measurement area and each of the second to fifth measurement areas were calculated. The maximum value among the differences is shown in Table 4 as "maximum value of differences".

The atom ratio Hf/RE or the atom ratio Zr/RE also was measured using TEM-EDS. Specifically, the grain boundary phase 4 that was present at a triple point selected randomly from ten locations from the first to fifth measurement areas for Examples 3, 4, 6, and 7 and Comparative Example 3; and the Hf amount or the Zr amount at each grain boundary phase 4 was measured by point analysis or area analysis by using TEM-EDS. The regions in which the atom ratio Hf/RE was not less than 0.01 and not more than 1.5 were taken as Hf-poor regions; and the regions in which the atom ratio Zr/RE was not less than 0.01 and not more than 1.5 were taken as Zr-poor regions. Also, the regions in which the atom ratio Hf/RE was greater than 1.5 were taken as Hf-rich regions; and the regions in which the atom ratio Zr/RE was greater than 1.5 were taken as Zr-rich regions. The presence of a poor region of Hf or Zr and the presence of a rich region of Hf or Zr each were checked, and the results are shown in Table 4. Also, whether or not (number of analysis points of poor regions)/(overall number of analysis points) was within the range of not less than 0.5 and not more than 1 for the poor region of Hf or Zr was checked; and the results are shown in Table 4.

[Table 4]

| | | Atom ratio Mg/RE | | | Atom ratio Hf/RE or Zr/RE | | |
|---|---|---|---|---|---|---|---|
| | | Minimum value | Maximum value | Maximum value of differences | Presence of poor region | Presence of rich region | Number of analysis points of poor regions/overall number of analysis points not less than 0.5 and not more than 1? |
| | Example 1 | 0.02 | 0.1 | 0.05 | - | - | - |
| | Example 2 | 0.06 | 0.8 | 0.5 | - | - | - |
| | Example 3 | 0.1 | 0.5 | 0.3 | Yes | No | Yes |
| | Example 4 | 0.4 | 1.0 | 0.5 | Yes | Yes | Yes |
| | Example 5 | 0.6 | 1.5 | 0.8 | - | - | - |
| | Example 6 | 0.8 | 1.3 | 0.4 | Yes | Yes | Yes |
| | Example 7 | 0.7 | 1.4 | 0.6 | Yes | No | Yes |
| | Example 8 | 0.5 | 1.1 | 0.4 | Yes | Yes | Yes |
| | Comparative Example 1 | 0.4 | 2.2 | 1.5 | - | - | - |
| | Comparative Example 2 | 0.3 | 5.2 | 4.4 | - | - | - |
| | Comparative Example 3 | 1.8 | 10.8 | 8.2 | Yes | Yes | No |
| | Comparative Example 4 | 0.2 | 4.9 | 3.1 | - | - | - |

It can be seen from Table 4 that the atom ratio Mg/RE was within the range of not less than 0.01 and not more than 1.5 for the silicon nitride substrates according to the examples. Also, the atom ratio Mg/RE difference between measurement areas that were adjacent to each other was not more than 0.8. In contrast, for the comparative examples, locations were observed at which the atom ratio Mg/RE was greater than 1.5.

Then, the presence of RE (rare-earth elements), Mg (magnesium), Si (silicon), and N (nitrogen) were confirmed using EDS analysis. SEM-EDS analysis was used for the EDS analysis for the qualitative analysis. Subsequently, the peak ratios of the $REMgSi_2O_5REMgSi_2O_5N$ crystal to the $\beta$-$Si_3N_4$ crystal was measured by performing XRD analysis. The peak ratio $(I_{29.5°})/(I_{27.0°})$, the peak ratio $(I_{27.8°})/(I_{27.0°})$, and the peak ratio $(I_{30.8°})/(I_{27.0°})$ each were measured. The XRD measurement conditions were as described above.

Also, the solid solution oxygen amount in the silicon nitride crystal grains was measured. TEM-EDS was used to measure the solid solution oxygen amount. All silicon nitride crystal grains present in the 5 $\mu$m$\times$5 $\mu$m measurement area were used as the measurement object, and the average value of the silicon nitride crystal grains was measured. The TEM-EDS measurement conditions were as described above. The results of the measurements are shown in Table 5.

[Table 5]

| | Presence of $REMgSi_2O_5N$ crystal | XRD peak ratio | | | Solid solution oxygen amount (mass%) |
|---|---|---|---|---|---|
| | | $(I_{29.5°})/(I_{27.0°})$ | $(I_{27.8°})/(I_{27.0°})$ | $(I_{30.8°})/(I_{27.0°})$ | |
| Example 1 | No | - | - | - | 0.08 |
| Example 2 | Yes | 0.02 | 0.01 | 0.03 | 0.12 |
| Example 3 | Yes | 0.05 | 0.02 | 0.02 | 0.08 |
| Example 4 | Yes | 0.04 | 0.01 | 0.01 | 0.15 |
| Example 5 | No | - | - | - | 0.15 |
| Example 8 | Yes | 0.08 | 0.03 | 0.01 | 0.18 |
| Example 7 | Yes | 0.12 | 0.04 | 0.05 | 0.18 |
| Example 8 | Yes | 0.02 | 0.01 | 0.01 | 0.12 |
| Comparative Example 1 | Yes | 0.05 | 0.01 | 0.03 | 0.19 |
| Comparative Example 2 | No | - | - | - | 0.33 |
| Comparative Example 3 | No | - | - | - | 0.50 |
| Comparative Example 4 | Yes | 0.02 | 0.01 | 0.01 | 0.10 |

The solid solution oxygen amount was not more than 0.2 mass% for the silicon nitride substrates according to the examples. When the solid solution oxygen amount in the silicon nitride crystal grains was not more than 0.2 mass%, the O/Si atomic ratio was not more than 0.042. The O/Si atomic ratio was greater than 0.042 when the solid solution oxygen amount was greater than 0.2 mass%, as in Comparative Example 2 and Comparative Example 3. Also, the XRD analysis peak ratios were within the favorable ranges for Examples 2, 3, 4, 6, 7, and 8 in which $REMgSi_2O_5N$ crystals were observed.

Then, the thermal conductivity and fracture toughness value of the silicon nitride substrate was measured. The thermal conductivity was measured by the flash method in accordance with JIS-R-1611 (2010). The fracture toughness value was measured by the IF method in accordance with JIS-R1607 (2015) and was calculated using Niihara's equation. The results are shown in Table 6.

[Table 6]

| | Thermal conductivity (W/m · K) | Fracture toughness value (MPa·m$^{1/2}$) |
|---|---|---|
| Example 1 | 105 | 8.1 |
| Example 2 | 122 | 7.5 |
| Example 3 | 135 | 7.8 |
| Example 4 | 111 | 6.5 |

(continued)

| | Thermal conductivity (W/m · K) | Fracture toughness value (MPa·m$^{1/2}$) |
|---|---|---|
| Example 5 | 102 | 8.8 |
| Example 6 | 109 | 7.5 |
| Example 7 | 122 | 8.1 |
| Example 8 | 117 | 7.2 |
| Comparative Example 1 | 82 | 7.1 |
| Comparative Example 2 | 77 | 6.8 |
| Comparative Example 3 | 69 | 5.5 |
| Comparative Example 4 | 110 | 6.4 |

It can be seen from Table 6 that the thermal conductivities of the silicon nitride substrates according to the examples were not less than 100 W/m·K. The fracture toughness values were not less than 6.0 MPa·m$^{1/2}$. It can be seen that high thermal conductivity and high strength were realized for the silicon nitride substrates according to the examples. The XRD analysis peak ratios based on the $REMgSi_2O_5N$ crystal and $\beta$-$Si_3N_4$ were within the prescribed ranges for Examples 2 to 4 and 6 to 8. Compared to Example 1 and Example 5, high thermal conductivities were obtained for these examples. It can be seen that the presence of $REMgSi_2O_5N$ crystals contributed to the improvement of the thermal conductivity.

Then, the relative dielectric constant of the silicon nitride substrate was measured. The relative dielectric constant was measured at 50 Hz, 1 MHz, or 10 MHz and at room temperature or 300 °C. The relative dielectric constant was measured in accordance with JIS-C-2141 (1992). The relative dielectric constant at 50 Hz and room temperature was taken as $\varepsilon_{50-25}$. The relative dielectric constant at 50 Hz and 300 °C was taken as $\varepsilon_{50-300}$. The relative dielectric constant at 1 MHz and room temperature was taken as $\varepsilon_{1M-25}$. The relative dielectric constant at 1 MHz and 300 °C was taken as $\varepsilon_{1M-300}$. The relative dielectric constant at 10 MHz and room temperature was taken as $\varepsilon_{10M-25}$. The results are shown in Tables 7 and 8.

[Table 7]

| | Relative dielectric constant | | | | |
|---|---|---|---|---|---|
| | 50Hz | | 1MHz | | 10MHz |
| | Room temperature | 300°C | Room temperature | 300°C | Room temperature |
| Example 1 | 8.3 | 8.4 | 8.3 | 8.7 | 8.4 |
| Example 2 | 8.2 | 8.4 | 8.3 | 8.6 | 8.4 |
| Example 3 | 7.8 | 7.9 | 7.6 | 8.0 | 7.6 |
| Example 4 | 8.2 | 8.3 | 8.2 | 8.5 | 8.3 |
| Example 5 | 8.2 | 8.2 | 8.3 | 8.7 | 8.4 |
| Example 6 | 8.4 | 8.4 | 8.2 | 8.4 | 8.2 |
| Example 7 | 8.2 | 8.3 | 8.2 | 8.5 | 8.2 |
| Example 8 | 8.4 | 8.6 | 8.4 | 8.7 | 8.8 |
| Comparative Example 1 | 8.4 | 8.7 | 8.4 | 9.1 | 9.3 |
| Comparative Example 2 | 8.3 | 8.8 | 8.3 | 9.4 | 9.3 |
| Comparative Example 3 | 8.2 | 9.3 | 8.7 | 9.7 | 9.6 |
| Comparative Example 4 | 8.3 | 9.4 | 8.4 | 9.4 | 9.2 |

[Table 8]

| | $\varepsilon_{50\text{-}300}/\varepsilon_{50\text{-}25}$ | $\varepsilon_{1M\text{-}300}/\varepsilon_{1M\text{-}25}$ | $\varepsilon_{1M\text{-}300}/\varepsilon_{50\text{-}300}$ | $\varepsilon_{10M\text{-}25}/\varepsilon_{1M\text{-}25}$ |
|---|---|---|---|---|
| Example 1 | 1.01 | 1.05 | 1.04 | 1.01 |
| Example 2 | 1.02 | 1.04 | 1.02 | 1.01 |
| Example 3 | 1.01 | 1.05 | 1.01 | 1.00 |
| Example 4 | 1.01 | 1.04 | 1.02 | 1.01 |
| Example 5 | 1.00 | 1.05 | 1.06 | 1.01 |
| Example 6 | 1.00 | 1.02 | 1.00 | 1.00 |
| Example 7 | 1.01 | 1.04 | 1.02 | 1.00 |
| Example 8 | 1.02 | 1.04 | 1.01 | 1.05 |
| Comparative Example 1 | 1.04 | 1.08 | 1.05 | 1.11 |
| Comparative Example 2 | 1.06 | 1.13 | 1.07 | 1.12 |
| Comparative Example 3 | 1.13 | 1.16 | 1.04 | 1.10 |
| Comparative Example 4 | 1.13 | 1.12 | 1.04 | 1.10 |

**It** can be seen from Tables 7 and 8 that the frequency dependence and temperature dependence of the relative dielectric constant was improved for the silicon nitride substrates according to the examples. For Examples 2 to 4 and 6 to 8, the relative dielectric constant $\varepsilon_{10M\text{-}25}$ was not more than 9.0 because $REMgSi_2O_5N$ crystals were present in the prescribed amounts. Also, $\varepsilon_{10M\text{-}25}/\varepsilon_{1M\text{-}25}$ was within the range of not less than 0.95 and not more than 1.09. In contrast, according to the comparative examples, $\varepsilon_{1M\text{-}300}$ was not less than 9.1; and the temperature dependence of the relative dielectric constant degraded in the high frequency domain. Also, $\varepsilon_{10M\text{-}25}/\varepsilon_{1M\text{-}25}$ was not less than 1.10; and the frequency dependence of the relative dielectric constant also degraded.

Thus, according to silicon nitride substrates according to examples, it can be seen that both improvement of the thermal conductivity and improvement of the relative dielectric constant can be realized.

While certain embodiments have been described, these embodiments have been presented by way of example only, and are not intended to limit the scope of the inventions. Indeed, the novel embodiments described herein may be embodied in a variety of other forms; furthermore, various omissions, substitutions, and changes in the form of the embodiments herein may be made without departing from the spirit of the inventions. The accompanying claims and their equivalents are intended to cover such forms or modifications as would fall within the scope and spirit of the inventions. Also, the embodiments above can be implemented in combination with each other.

[Reference Numeral List]

1 silicon nitride substrate
2 cross section
3 silicon nitride crystal grain
4, 4A grain boundary phase
5 circuit part (metal plate)
6 heat dissipation plate
7 bonding layer
8 semiconductor element
9A point analysis region
9B area analysis region
10 silicon nitride circuit board
20 semiconductor device

**Claims**

1. A silicon nitride sintered compact, comprising:

   silicon nitride crystal grains and a grain boundary phase,
   the silicon nitride sintered compact being highly thermally-conductive,
   a thermal conductivity of the silicon nitride sintered compact being not less than 100 W/m·K,
   in any cross section, a grain boundary phase present in a 5 μm×5 μm measurement area including Mg and a rare-earth element (RE),
   an atom ratio of Mg to rare-earth element being within a range of not less than 0.01 and not more than 1.5,
   a relative dielectric constant $\varepsilon_{10M-25}$ at 10 MHz and room temperature being not more than 9.0.

2. The silicon nitride sintered compact according to claim 1, wherein
   a difference between the atom ratios of Mg to rare-earth element of the measurement areas that are adjacent to each other in the cross section is not more than 0.8.

3. The silicon nitride sintered compact according to claim 1 or claim 2, wherein

   in an XRD analysis result of any cross section of the silicon nitride sintered compact, a peak ratio $(I_{29.5°})/(I_{27.0°})$ is within a range of not less than 0.01 and not more than 0.15,
   $I_{27.0°}$ being a maximum peak intensity detected at 27.0±0.3° based on a β-$Si_3N_4$ crystal, $I_{29.5°}$ being a maximum peak intensity detected at 29.5±0.3° based on a REMgSi$_2$O$_5$N crystal.

4. The silicon nitride sintered compact according to claim 1 or claim 2, wherein

   in an XRD analysis of any cross section of the silicon nitride sintered compact, a peak is detected at one or both of 27.8±0.3° and 30.8±0.3° based on a REMgSi$_2$O$_5$N crystal, and
   at least one of a peak ratio $(I_{27.8°})/(I_{27.0°})$ being not less than 0.005 and not more than 0.05 or a peak ratio $(I_{30.8°})/(I_{27.0°})$ being not less than 0.005 and not more than 0.05 is satisfied,
   based on a β-$Si_3N_4$ crystal, $I_{27.0°}$ being a maximum peak intensity detected at 27.0±0.3°, $I_{27.8}$ being a maximum peak intensity detected at 27.8±0.3°, $I_{30.8°}$ being a maximum peak intensity detected at 30.8±0.3°.

5. The silicon nitride sintered compact according to claim 3, wherein

   in an XRD analysis of any cross section of the silicon nitride sintered compact, a peak is detected at one or both of 27.8±0.3° and 30.8±0.3° based on a REMgSi$_2$O$_5$N crystal, and
   at least one of a peak ratio $(I_{27.8°})/(I_{27.0°})$ being not less than 0.005 and not more than 0.05 or a peak ratio $(I_{30.8°})/(I_{27.0°})$ being not less than 0.005 and not more than 0.05 is satisfied,
   based on a β-$Si_3N_4$ crystal, $I_{27.0°}$ being a maximum peak intensity detected at 27.0±0.3°, $I_{27.8}$ being a maximum peak intensity detected at 27.8±0.3°, $I_{30.8°}$ being a maximum peak intensity detected at 30.8±0.3°.

6. The silicon nitride sintered compact according to claim 1 or claim 2, wherein

   in the 5 μm×5 μm measurement area, the grain boundary phase includes at least one of Hf or Zr, and
   a region is present in which an atom ratio of Hf to rare-earth element is not less than 0.01 and not more than 1.5, and a region is present in which the atom ratio of Hf to rare-earth element is greater than 1.5; or a region is present in which an atom ratio of Zr to rare-earth element is not less than 0.01 and not more than 1.5, and a region is present in which the atom ratio of Zr to rare-earth element is greater than 1.5.

7. The silicon nitride sintered compact according to claim 3, wherein

   in the 5 μm×5 μm measurement area, the grain boundary phase includes at least one of Hf or Zr, and
   a region is present in which an atom ratio of Hf to rare-earth element is not less than 0.01 and not more than 1.5, and a region is present in which the atom ratio of Hf to rare-earth element is greater than 1.5; or a region is present in which an atom ratio of Zr to rare-earth element is not less than 0.01 and not more than 1.5, and a region is present in which the atom ratio of Zr to rare-earth element is greater than 1.5.

8. The silicon nitride sintered compact according to claim 1 or claim 2, wherein

an average oxygen amount in the silicon nitride crystal grains is not more than 0.2 mass%.

9. The silicon nitride sintered compact according to claim 3, wherein
an average oxygen amount in the silicon nitride crystal grains is not more than 0.2 mass%.

10. The silicon nitride sintered compact according to claim 1 or claim 2, wherein

$\varepsilon_{50\text{-}300}/\varepsilon_{50\text{-}25}$ is within a range of not less than 0.95 and not more than 1.09,
$\varepsilon_{50\text{-}25}$ being a relative dielectric constant at 50 Hz and room temperature, $\varepsilon_{50\text{-}300}$ being a relative dielectric constant at 50 Hz and at 300 °C.

11. The silicon nitride sintered compact according to claim 7, wherein

$\varepsilon_{50\text{-}300}/\varepsilon_{50\text{-}25}$ is within a range of not less than 0.95 and not more than 1.09,
$\varepsilon_{50\text{-}25}$ being a relative dielectric constant at 50 Hz and room temperature, $\varepsilon_{50\text{-}300}$ being a relative dielectric constant at 50 Hz and at 300 °C.

12. The silicon nitride sintered compact according to claim 9, wherein

$\varepsilon_{10M\text{-}25}/\varepsilon_{1M\text{-}25}$ is within a range of not less than 0.95 and not more than 1.09,
$\varepsilon_{1M\text{-}25}$ being a relative dielectric constant at 1 MHz and room temperature.

13. The silicon nitride sintered compact according to claim 10, wherein

$\varepsilon_{10M\text{-}25}/\varepsilon_{1M\text{-}25}$ is within a range of not less than 0.95 and not more than 1.09,
$\varepsilon_{1M\text{-}25}$ being a relative dielectric constant at 1 MHz and room temperature.

14. The silicon nitride sintered compact according to claim 11, wherein

$\varepsilon_{10M\text{-}25}/\varepsilon_{1M\text{-}25}$ is within a range of not less than 0.95 and not more than 1.09,
$\varepsilon_{1M\text{-}25}$ being a relative dielectric constant at 1 MHz and room temperature.

15. A silicon nitride substrate, comprising:
the silicon nitride sintered compact according to claim 1 or claim 2.

16. A silicon nitride substrate, comprising:
the silicon nitride sintered compact according to claim 3.

17. A silicon nitride substrate, comprising:
the silicon nitride sintered compact according to claim 7.

18. A silicon nitride substrate, comprising:
the silicon nitride sintered compact according to claim 11.

19. A silicon nitride circuit board, comprising:

the silicon nitride substrate according to claim 15; and
a circuit part located on the silicon nitride substrate.

20. A semiconductor device, comprising:

the silicon nitride circuit board according to claim 19; and
a semiconductor element mounted on the circuit part.

FIG. 1

FIG. 2

(GRAIN BOUNDARY PHASE PRESENT AT TRIPLE POINT)
4A

3

3

9A
(POINT ANALYSIS)

9B
(AREA ANALYSIS)

FIG. 3

FIG. 4

FIG. 5

<div align="center">**INTERNATIONAL SEARCH REPORT**</div>

| International application No. |
| --- |
| **PCT/JP2023/040093** |

| A. | CLASSIFICATION OF SUBJECT MATTER |
| --- | --- |

*C04B 35/587*(2006.01)i; *H01L 23/15*(2006.01)i
FI:   C04B35/587; H01L23/14 C

According to International Patent Classification (IPC) or to both national classification and IPC

| B. | FIELDS SEARCHED |
| --- | --- |

Minimum documentation searched (classification system followed by classification symbols)

C04B35/587; H01L23/15

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | JP 2022-153934 A (HITACHI METALS, LIMITED) 13 October 2022 (2022-10-13) | 1-20 |
| A | JP 2014-58445 A (HITACHI METALS, LIMITED) 03 April 2014 (2014-04-03) | 1-20 |
| A | JP 2003-313079 A (HITACHI METALS, LIMITED) 06 November 2003 (2003-11-06) | 1-20 |
| A | JP 2001-339162 A (KYOCERA CORPORATION) 07 December 2001 (2001-12-07) | 1-20 |
| A | WO 2016/117553 A1 (KABUSHIKI KAISHA TOSHIBA) 28 July 2016 (2016-07-28) | 1-20 |
| A | US 4608354 A (GTE LABORATORIES INCORPORATED) 26 August 1986 (1986-08-26) | 1-20 |

☐ Further documents are listed in the continuation of Box C.      ☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **22 December 2023** | **23 January 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2023/040093**

| Patent document cited in search report | | | Publication date (day/month/year) | Patent family member(s) | | | Publication date (day/month/year) |
|---|---|---|---|---|---|---|---|
| JP | 2022-153934 | A | 13 October 2022 | (Family: none) | | | |
| JP | 2014-58445 | A | 03 April 2014 | US | 2011/0176277 | A1 | |
| | | | | CN | 102105418 | A | |
| JP | 2003-313079 | A | 06 November 2003 | (Family: none) | | | |
| JP | 2001-339162 | A | 07 December 2001 | (Family: none) | | | |
| WO | 2016/117553 | A1 | 28 July 2016 | US | 2018/0002237 | A1 | |
| | | | | CN | 107207366 | A | |
| US | 4608354 | A | 26 August 1986 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6293772 B
- WO 2018194052 A
- JP 2022153934 A
- JP 2022071426 A